# FASCICULE DE BREVET EUROPEEN

(11) **EP 3 846 595 B1**
(45) Date de publication et mention de la délivrance du brevet: **19.10.2022**
(21) Numéro de dépôt: 20213793.1
(22) Date de dépôt: 14.12.2020
(51) Int. Cl.: H05H 7/00

(54) **DÉTECTEUR DE POSITION D'UN FAISCEAU DE PARTICULES CHARGÉES TRAVERSANT UNE ENCEINTE**
POSITIONSDETEKTOR EINES STRAHLS MIT GELADENEN TEILCHEN, DER EIN GEHÄUSE DURCHQUERT
DETECTOR OF THE POSITION OF A BEAM OF CHARGED PARTICLES PASSING THROUGH AN ENCLOSURE

(30) Priorité: 17.12.2019 FR 1914595
(43) Date de publication de la demande: 07.07.2021
(73) Titulaire: Commissariat à l'énergie atomique et aux énergies alternatives, 75015 Paris (FR)
(72) Inventeur: NICOLAS, Rémi, 21120 IS SUR TILLE (FR)
(74) Mandataire: Brevalex

(56) Documents cités:
- M.SHAFIEE ET AL: "Design and construction of Inductive BPM", PROCEEDINGS OF IPAC2012, NEW ORLEANS, LOUISIANA, USA, juillet 2012 (2012-07), pages 289-291, XP002800130, ISBN: 978-3-95450-115-1
- M. GASIOR: "A Current Mode Inductive Pick-up for Beam Position and Current Measurement", PROCEEDINGS OF DIPAC 2005, LYON, FRANCE, juillet 2005 (2005-07), pages 175-177, XP002800131,
- V.A. VERZILOV ET AL: "A New Beam Position Monitor for the TRIUMF Cyclotron Beamlines", CYCLOTRONSAND THEIR APPLICATIONS 2007, 18TH INTERNATIONAL CONFERENCE, GIARDINI NAXOS, ITALY, 1 octobre 2007 (2007-10-01), pages 331-333, XP002800132,
- BARRY W ED - UNNO YOSHINOBU ET AL: "A GENERAL ANALYSIS OF THIN WIRE PICKUPS FOR HIGH FREQUENCY BEAM POSITION MONITORS *", NUCLEAR INSTRUMENTS & METHODS IN PHYSICS RESEARCH. SECTION A, ELSEVIER BV * NORTH-HOLLAND, NL, vol. A301, no. 3, 15 mars 1991 (1991-03-15), pages 407-416, XP000227144, ISSN: 0168-9002, DOI: 10.1016/0168-9002(91)90004-A

## Description

### DOMAINE TECHNIQUE

L'invention se situe dans le domaine de la détection non-intrusive de la position d'un faisceau de particules chargées électriquement et traversant une enceinte. Elle concerne un détecteur de position de faisceau comprenant au moins deux capteurs de champ magnétique disposés dans l'enceinte de part et d'autre du faisceau de particules. L'invention concerne également un système de mesure comprenant un tel détecteur et une chaîne de traitement agencée pour déterminer la position du faisceau à partir des signaux fournis par les capteurs de champ magnétique. L'invention porte enfin sur un accélérateur de particules comprenant une enceinte agencée pour guider un faisceau de particules chargées, et un détecteur de position de faisceau ou un système de mesure.

L'invention s'applique notamment à la détection de la position d'un faisceau de particules dans un accélérateur de particules mais peut être utilisée pour la détection de la position de tout faisceau de particules chargées électriquement traversant une enceinte, quelles que soient les dimensions de l'enceinte et quelle que soit l'intensité du faisceau de particules. En particulier, l'invention peut être utilisée dans un microscope électronique, avec des moteurs ioniques ou avec des machines médicales de radiothérapie ou de proton-thérapie.

### ÉTAT DE LA TECHNIQUE ANTÉRIEURE

Dans un accélérateur de particules, il est nécessaire de contrôler précisément la position du faisceau de particules traversant le tube, notamment pour pouvoir guider précisément le faisceau de particules jusqu'à son point d'impact. À cette fin, le tube comprend une multitude de détecteurs de position de faisceau répartis sur sa longueur. Les détecteurs de position de faisceau sont appelés « Beam Position Monitors » (BPM) dans la littérature anglo-saxonne. Chaque détecteur de position de faisceau comporte généralement quatre capteurs de champ magnétique, couramment appelés capteurs B-dot, disposés au niveau de l'enveloppe interne du tube. Chaque capteur de champ magnétique comprend une boucle conductrice aux bornes de laquelle une tension (force électromotrice) est générée par une variation du champ magnétique résultant du passage du faisceau de particules. Deux capteurs de champ magnétique sont installés sur un axe vertical, de part et d'autre de l'axe longitudinal du tube, de façon à fournir une information de position le long de cet axe vertical par comparaison des tensions générées dans leurs boucles, et deux capteurs de champ magnétique sont installés sur un axe horizontal, de part et d'autre de l'axe du tube, de façon à fournir une information de position le long de cet axe horizontal par comparaison des tensions générées dans leurs boucles. En pratique, les signaux issus des capteurs de champ magnétique de chaque paire sont injectés dans un additionneur. Du fait de la position symétrique des capteurs de champ magnétique, le signal issu de l'additionneur est représentatif de la différence d'amplitude de tension entre les deux boucles. Une sortie de l'additionneur est ensuite connectée à un intégrateur associé à un moyen de numérisation. Afin d'éviter l'intégration ou la numérisation d'un signal d'amplitude quasi nulle, les signaux issus des capteurs de champ magnétique sont atténués avec des facteurs d'atténuation différents préalablement à leur intégration et à leur numérisation. À titre d'exemple, l'un des atténuateurs peut présenter un facteur d'atténuation de 3 dB tandis que l'autre atténuateur peut présenter un facteur d'atténuation de 6 dB. L'introduction des atténuateurs dans la chaîne de mesure présente toutefois l'inconvénient de diminuer l'amplitude des signaux de mesure, conduisant à une dégradation du rapport signal sur bruit et donc de la précision du positionnement du faisceau de particules.

Compte tenu de ce qui précède, l'invention a pour objectif de fournir un détecteur de position de faisceau présentant une précision accrue. L'invention a encore pour objectif de fournir un détecteur de position de faisceau dont les coûts de conception, de fabrication et de maintenance sont réduits. Un exemple de capteur inductif de position de faisceau est divulgué en M.SHAFIEE ET AL: "Design and Construction of Inductive BPM", PROCEEDINGS OF IPAC2012, NEW ORLEANS, LOUISIANA, USA, juillet 2012 (2012-07), pages 289-291 ,ISBN: 978-3-95450-115-1.

D'autres exemples sont divulgués en M. GASIOR: "A Current Mode Inductive Pick-up for Beam Position and Current Measurement", PROCEEDINGS OF DIPAC 2005, LYON, FRANCE, juillet 2005 (2005-07), pages 175-177,et en V.A. VERZILOV ET AL: "A New Beam Position Monitor for the TRIUMF Cyclotron Beamlines",CYCLOTRONS AND THEIR APPLICATIONS 2007, 18TH INTERNATIONAL CONFERENCE, GIARDINI NAXOS, ITALY, 1 octobre 2007 (2007-10-01), pages 331-333

### EXPOSÉ DE L'INVENTION

À cet effet, l'invention repose sur l'utilisation de paires de capteurs de champ magnétique dont les boucles conductrices présentent des inductances différentes l'une de l'autre. La dissymétrie d'amplitude des signaux est alors introduite par les capteurs eux-mêmes, rendant inutile la présence des atténuateurs. La suppression des atténuateurs permet de conserver une amplitude de signal maximale avant traitement et de diminuer le nombre de connecteurs dans la chaîne de traitement.

Plus précisément, l'invention a pour objet un détecteur de position de faisceau pour mesurer une position d'un faisceau de particules chargées traversant une enceinte, le détecteur de position de faisceau comprenant un premier capteur de champ magnétique et un deuxième capteur de champ magnétique agencés pour être installés dans l'enceinte de part et d'autre du faisceau de particules, chaque capteur de champ magnétique comprenant une boucle conductrice. Selon l'invention, la boucle conductrice du premier capteur de champ magnétique et la boucle conductrice du deuxième capteur de champ magnétique sont agencées pour présenter des inductances différentes l'une de l'autre.

Autrement dit, la boucle conductrice du premier capteur de champ magnétique et la boucle conductrice du deuxième capteur de champ magnétique sont agencées pour qu'un rapport entre leurs inductances soit un nombre réel positif différent de zéro et de un.

Les capteurs de champ magnétique sont de préférence installés dans l'enceinte de sorte que leurs boucles conductrices soient disposées symétriquement l'une de l'autre par rapport à une position attendue de l'axe de propagation du faisceau de particules. Typiquement, la position attendue de l'axe de propagation du faisceau de particules correspond à la position d'un axe de symétrie de l'enceinte. Pour un accélérateur de particules, cet axe correspond à l'axe longitudinal de son tube.

La boucle conductrice du premier capteur de champ magnétique et la boucle conductrice du deuxième capteur de champ magnétique peuvent présenter des nombres de spires différents l'un de l'autre et/ou des formes différentes l'une de l'autre et/ou des dimensions différentes l'une de l'autre. Les spires de chaque boucle conductrice sont de préférence coaxiales.

Selon une première forme particulière de réalisation, la boucle conductrice du premier capteur de champ magnétique et la boucle conductrice du deuxième capteur de champ magnétique présentent chacune une seule spire, de formes différentes l'une de l'autre et/ou de dimensions différentes l'une de l'autre. Plus généralement, la boucle conductrice du premier capteur de champ magnétique et la boucle conductrice du deuxième capteur de champ magnétique peuvent présenter chacune un même nombre de spires, de formes différentes les unes des autres et/ou de dimensions différentes les unes des autres. Dans chaque boucle conductrice, la forme et les dimensions de ses différentes spires sont de préférence identiques.

Selon une deuxième forme particulière de réalisation, la boucle conductrice du premier capteur de champ magnétique et la boucle conductrice du deuxième capteur de champ magnétique présentent des spires de même forme et de mêmes dimensions en nombres différents. Autrement dit, la boucle conductrice du premier capteur de champ magnétique présente un nombre de spires différent du nombre de spires de la boucle conductrice du deuxième capteur de champ magnétique, les spires de la boucle conductrice du premier capteur de champ magnétique et les spires de la boucle conductrice du deuxième capteur de champ magnétique présentant une forme identique et des dimensions identiques. Un rapport entre les inductances des premier et deuxième capteurs de champ magnétique est alors un nombre entier supérieur ou égal à deux.

Le premier capteur de champ magnétique et le deuxième capteur de champ magnétique forment une première paire de capteurs de position, agencés pour fournir une information de position du faisceau de particules le long d'un premier axe passant par ces capteurs de champ magnétique. Ce premier axe est par exemple un axe vertical, perpendiculaire à l'axe de symétrie de l'enceinte.

Le détecteur de position de faisceau peut comprendre, en outre, un troisième capteur de champ magnétique et un quatrième capteur de champ magnétique agencés pour être installés dans l'enceinte de part et d'autre du faisceau de particules, chaque capteur de champ magnétique comprenant une boucle conductrice. La boucle conductrice du troisième capteur de champ magnétique et la boucle conductrice du quatrième capteur de champ magnétique sont de préférence agencées pour présenter des inductances différentes l'une de l'autre.

Le troisième capteur de champ magnétique et le quatrième capteur de champ magnétique forment alors une deuxième paire de capteurs de position, agencés pour fournir une information de position du faisceau de particules le long d'un deuxième axe passant par ces capteurs de champ magnétique. Ce deuxième axe est par exemple un axe horizontal, perpendiculaire à l'axe de symétrie de l'enceinte.

De préférence, le premier capteur de champ magnétique, le deuxième capteur de champ magnétique, le troisième capteur de champ magnétique et le quatrième capteur de champ magnétique sont agencés dans un même plan perpendiculaire au faisceau de particules. En d'autres termes, le deuxième axe est perpendiculaire au premier axe. Les capteurs de position sont alors répartis angulairement autour de l'axe de symétrie de l'enceinte avec un angle de 90 degrés. Une telle disposition permet de déterminer la position du faisceau de particules dans un plan perpendiculaire à l'axe de symétrie de l'enceinte. Ce plan est appelé « plan de mesure ».

Le détecteur de position de faisceau peut comprendre, en outre, un cinquième capteur de champ magnétique et un sixième capteur de champ magnétique agencés pour être installés dans l'enceinte de part et d'autre du faisceau de particules, chaque capteur de champ magnétique comprenant une boucle conductrice. La boucle conductrice du cinquième capteur de champ magnétique et la boucle conductrice du sixième capteur de champ magnétique sont par exemple agencées pour présenter une même inductance.

Selon une forme particulière de réalisation, le détecteur de position de faisceau comprend, en outre, un châssis agencé pour être fixé à l'enceinte et/ou former un tronçon de l'enceinte. Le châssis comprend :
▪ une ouverture centrale agencée pour laisser passer le faisceau de particules, et
▪ une cavité de réception pour chaque capteur de champ magnétique, chaque cavité de réception débouchant dans l'ouverture centrale et étant agencée pour recevoir l'un des capteurs de champ magnétique.

L'invention a également pour objet un système de mesure comprenant un détecteur de position de faisceau tel que décrit précédemment et un premier additionneur, le premier additionneur étant agencé pour délivrer un premier signal de différence représentatif d'une différence d'amplitude entre un signal délivré par le premier capteur de champ magnétique et un signal délivré par le deuxième capteur de champ magnétique.

Le système de mesure peut comprendre, en outre, un premier intégrateur agencé pour recevoir le premier signal de différence et délivrer un premier signal intégré correspondant à une intégration temporelle du premier signal de différence.

Lorsque le détecteur de position comprend des troisième et quatrième capteurs de champ magnétique, le système de mesure peut de plus comporter un deuxième additionneur, le deuxième additionneur étant agencé pour délivrer un deuxième signal de différence représentatif d'une différence d'amplitude entre un signal délivré par le troisième capteur de champ magnétique et un signal délivré par le quatrième capteur de champ magnétique.

Le système de mesure peut comprendre, en outre, un deuxième intégrateur agencé pour recevoir le deuxième signal de différence et délivrer un deuxième signal intégré correspondant à une intégration temporelle du deuxième signal de différence.

Selon une forme particulière de réalisation, chaque additionneur est connecté directement aux capteurs de champ magnétique. Une connexion directe s'entend d'une connexion agencée pour relier deux éléments sans modifier les propriétés du signal transporté. Une connexion directe est typiquement établie par un câble coaxial. En particulier, la connexion entre chaque additionneur et les capteurs de champ magnétique peut être dépourvue d'atténuateur.

Les additionneurs peuvent être des composants analogiques. Les signaux additionnés sont alors déterminés sur la base de signaux de mesure analogiques, ce qui évite une perte d'informations.

De même, les intégrateurs peuvent être des composants analogiques. Les signaux intégrés peuvent alors être déterminés sur la base de signaux issus d'une sommation analogique, ce qui évite une perte d'informations par numérisation.

Le système de mesure peut comprendre, en outre, un numériseur agencé pour recevoir chaque signal intégré au format analogique et délivrer un signal intégré numérisé correspondant.

L'invention a enfin pour objet un accélérateur de particules comprenant une enceinte agencée pour guider un faisceau de particules chargées, et le détecteur de position de faisceau ou le système de mesure tels que décrits précédemment.

### BRÈVE DESCRIPTION DES DESSINS

D'autres caractéristiques, détails et avantages de l'invention ressortiront à la lecture de la description qui va suivre, donnée uniquement à titre d'exemple et faite en référence aux dessins annexés pour lesquels :
- la figure 1 représente schématiquement un exemple de système de mesure selon l'état de la technique pour mesurer une position d'un faisceau d'électrons dans un tube d'un accélérateur de particules ;
- la figure 2A représente, dans une vue en perspective, un capteur de champ magnétique du système de mesure de la figure 1 ;
- la figure 2B représente le capteur de champ magnétique de la figure 2A dans une vue en coupe longitudinale ;
- la figure 3A représente, dans une vue en perspective, un exemple de capteur de champ magnétique pour un système de mesure selon l'invention ;
- la figure 3B représente, dans une vue de côté, le capteur de champ magnétique de la figure 3A ;
- la figure 3C représente, dans une vue en coupe longitudinale, le capteur de champ magnétique des figures 3A et 3B ;
- la figure 4 représente schématiquement un exemple de système de mesure selon l'invention ;
- la figure 5 représente, sur un graphique, des exemples de signaux intégrés obtenus avec le système de mesure de la figure 1 et avec le système de mesure de la figure 4.

### DESCRIPTION DÉTAILLÉE

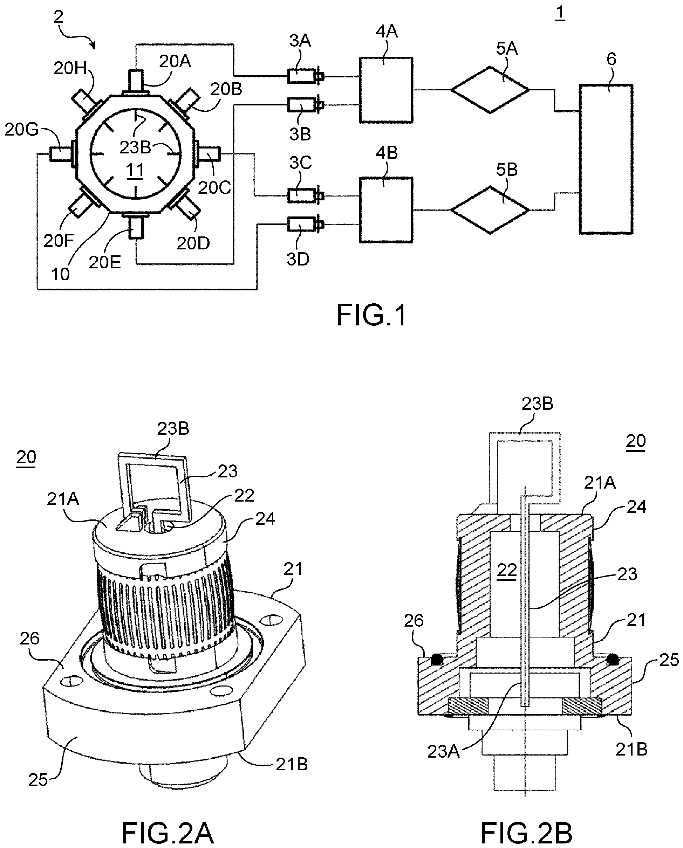

La figure 1 représente schématiquement un exemple de système de mesure selon l'état de la technique pour mesurer une position d'un faisceau d'électrons dans un tube d'un accélérateur de particules. Le tube présente typiquement une ouverture centrale s'étendant selon un axe longitudinal ou selon un arc de cercle. L'accélérateur de particules est agencé pour que le faisceau d'électrons se propage sur cet axe longitudinal ou sur cet arc de cercle. Le système de mesure 1 comprend un détecteur de position de faisceau 2, quatre atténuateurs 3A, 3B, 3C, 3D, deux additionneurs 4A, 4B, deux intégrateurs 5A, 5B et un numériseur 6. Le détecteur de position de faisceau 2 comprend un châssis 10 et huit capteurs de champ magnétique 20A, 20B, 20C, 20D, 20E, 20F, 20G, 20H, désignés globalement par la référence 20. Le châssis 10 présente une forme globalement cylindrique et est agencé pour être fixé au moins à l'une de ses extrémités longitudinales à un tronçon du tube de l'accélérateur de particules. Le châssis 10 comporte une ouverture centrale 11 et huit cavités de réception, non représentées, chacune débouchant dans l'ouverture centrale 11 et étant agencée pour recevoir l'un des capteurs de champ magnétique 20. Le châssis 10 et son ouverture centrale 11 sont agencés de sorte que le détecteur de position de faisceau 2 forme un tronçon du tube de l'accélérateur de particules. En particulier, le diamètre de l'ouverture centrale 11 est sensiblement égal au diamètre interne du tronçon de tube auquel le châssis 10 est fixé.

Les figures 2A et 2B représentent en détail, dans une vue en perspective et dans une vue en coupe longitudinale, respectivement, les capteurs de champ magnétique 20. Les capteurs de champ magnétique 20 sont couramment appelés « capteur B-dot ». Chaque capteur comporte un corps 21, un trou débouchant 22 et un élément conducteur 23. Le corps 21 comprend une partie tubulaire 24 et une embase 25. La partie tubulaire 24 est agencée pour pouvoir être insérée dans une cavité de réception du châssis 10. L'embase 25 présente un diamètre supérieur au diamètre de la partie tubulaire 24, de manière à former un épaulement 26 agencé pour venir en appui sur une surface extérieure du châssis 10. Le trou débouchant 22 s'étend dans la partie tubulaire 24 et dans l'embase 25 du corps 21. Il est agencé pour permettre à l'élément conducteur 23 de traverser le corps 21 entre une première extrémité 21A, destinée à déboucher dans l'ouverture centrale 11 du châssis 10, et une deuxième extrémité 21B, accessible depuis l'extérieur du châssis 10 lorsque le capteur de champ magnétique 20 est accueilli dans une cavité de réception du châssis 10. L'élément conducteur 23 comprend une partie rectiligne 23A s'étendant entre les extrémités 21A et 21B du corps 21, et une boucle 23B formée du côté de l'extrémité 21A. La boucle 23B est formée d'une simple spire et est connectée par son extrémité libre au corps 21. Le capteur de champ magnétique 20 permet ainsi de générer une tension entre l'élément conducteur 23 et le corps 21 lors d'une variation du champ magnétique due au passage d'un faisceau d'électrons.

Il est à nouveau fait référence à la figure 1. Le détecteur de position de faisceau 2 et les capteurs de champ magnétique 20 sont agencés de sorte que les boucles 23B des capteurs de champ magnétique 20 soient situées dans un même plan de mesure et réparties angulairement autour du centre de l'ouverture centrale 11 du châssis 10. En particulier, dans le cas d'un détecteur de position de faisceau 2 comprenant huit capteurs de champ magnétique, les boucles 23B sont réparties avec un angle de 45 degrés. Afin de pouvoir mesurer une variation du champ magnétique due au passage d'un faisceau d'électrons dans le plan de mesure, chaque boucle 23B est formée dans un plan passant par l'axe de propagation du faisceau d'électrons.

Les capteurs de champ magnétique 20 sont utilisés par paires, chaque paire comprenant un capteur formant une voie dite positive et un capteur formant une voie dite négative. Les capteurs de champ magnétique 20A et 20E sont disposés sur un axe vertical et forment une paire de capteurs de position verticale ; les capteurs de champ magnétique 20C et 20G sont disposés sur un axe horizontal et forment une paire de capteurs de position horizontale. Les capteurs de champ magnétique 20B et 20F sont disposés sur un axe incliné de 45 degrés par rapport à l'axe vertical et forment une première paire de capteurs d'intensité ; les capteurs de champ magnétique 20D et 20H sont disposés sur un axe incliné de - 45 degrés par rapport à l'axe vertical et forment une deuxième paire de capteurs d'intensité. Dans chaque paire, les capteurs de champ magnétique 20 sont disposés symétriquement l'un de l'autre par rapport au centre de l'ouverture centrale 11 du châssis 10, c'est-à-dire symétriquement par rapport à l'axe de propagation du faisceau d'électrons. Plus précisément, dans chaque paire, le centre de la boucle conductrice de l'un des capteurs de champ magnétique 20 est disposé symétriquement du centre de la boucle conductrice de l'autre capteur de champ magnétique 20.

Le capteur de champ magnétique 20A est relié à une première entrée de l'additionneur 4A par l'intermédiaire de l'atténuateur 3A et le capteur de champ magnétique 20E est relié à une deuxième entrée de l'additionneur 4A par l'intermédiaire de l'atténuateur 3B. De manière analogue, le capteur de champ magnétique 20C est relié à une première entrée de l'additionneur 4B par l'intermédiaire de l'atténuateur 3C et le capteur de champ magnétique 20G est relié à une deuxième entrée de l'additionneur 4B par l'intermédiaire de l'atténuateur 3D. Les atténuateurs 3A et 3B, respectivement 3C et 3D présentent des facteurs d'atténuation distincts l'un de l'autre. À titre d'exemple, les atténuateurs 3A et 3C présentent un facteur d'atténuation de 3 dB tandis que les atténuateurs 3B et 3D présentent un facteur d'atténuation de 6 dB. Les additionneurs 4A et 4B sont des composants analogiques passifs. L'additionneur 4A additionne les signaux issus des atténuateurs 3A et 3B. Plus précisément, il délivre un signal de différence verticale dont l'amplitude correspond à la différence entre l'amplitude de la tension aux bornes du capteur de champ magnétique 20A, après atténuation, et l'amplitude de la tension aux bornes du capteur de champ magnétique 20E, après atténuation. L'additionneur 4B additionne les signaux issus des atténuateurs 3C et 3D. Plus précisément, il délivre un signal de différence horizontale dont l'amplitude correspond à la différence entre l'amplitude de la tension aux bornes du capteur de champ magnétique 20C, après atténuation, et l'amplitude de la tension aux bornes du capteur de champ magnétique 20G, après atténuation. Une sortie de l'additionneur 4A est reliée à une entrée de l'intégrateur 5A et une sortie de l'additionneur 4B est reliée à une entrée de l'intégrateur 5B. Les intégrateurs 5A et 5B sont des composants analogiques passifs. L'intégrateur 5A intègre dans le domaine temporel le signal de différence verticale pour donner un signal intégré vertical et l'intégrateur 5B intègre dans le domaine temporel le signal de différence horizontale pour donner un signal intégré horizontal. Une sortie de l'intégrateur 5A et une sortie de l'intégrateur 5B sont reliées individuellement à des entrées du numériseur 6 agencé pour numériser les signaux intégrés. Les signaux intégrés numérisés peuvent ensuite faire l'objet d'un traitement du signal afin de déterminer une position du faisceau d'électrons dans le plan de mesure.

L'application de facteurs d'atténuation différenciés entre les voies positive et négative permet d'intégrer un signal de différence dont l'amplitude est éloignée de la valeur nulle, y compris lorsque le faisceau d'électrons est parfaitement centré dans le tube. La numérisation du signal intégré et l'extraction d'informations temporelles en sont facilitées.

Par ailleurs, les capteurs de champ magnétique 20B et 20F peuvent également être reliés aux entrées d'un troisième additionneur, non représenté, afin de générer un premier signal d'intensité dont l'amplitude correspond à la somme de l'amplitude de la tension aux bornes du capteur de champ magnétique 20B et de l'amplitude de la tension aux bornes du capteur de champ magnétique 20F. De manière analogue, les capteurs de champ magnétique 20D et 20H peuvent être reliés aux entrées d'un quatrième additionneur, non représenté, afin de générer un deuxième signal d'intensité dont l'amplitude correspond à la somme de l'amplitude de la tension aux bornes du capteur de champ magnétique 20D et de l'amplitude de la tension aux bornes du capteur de champ magnétique 20H. L'utilisation d'atténuateurs n'est pas nécessaire pour ces paires de capteurs d'intensité dans la mesure où les additionneurs sont agencés pour additionner les amplitudes des signaux et non pour soustraire l'une à l'autre. Une sortie du troisième additionneur peut être reliée à une entrée d'un troisième intégrateur agencé pour délivrer un premier signal d'intensité intégré correspondant à l'intégration temporelle du premier signal d'intensité. De même, une sortie du quatrième additionneur peut être reliée à une entrée d'un quatrième intégrateur agencé pour délivrer un deuxième signal d'intensité intégré correspondant à l'intégration temporelle du deuxième signal d'intensité. Les signaux d'intensité intégrés peuvent être numérisés et moyennés afin de déterminer une intensité du faisceau d'électrons. Cette fonction est une sommation simple des signaux issus des capteurs 20B, 20D, 20F et 20H.

L'intensité du champ magnétique mesurée par les capteurs de champ magnétique 20A, 20C, 20E, 20G formant la paire de capteurs de position verticale et la paire de capteurs de position horizontale est proportionnelle non seulement à la position du barycentre des charges transportées par le faisceau d'électrons, mais aussi à l'intensité de ce faisceau d'électrons. Par conséquent, la détermination complète de la position du faisceau d'électrons requiert d'une part une exploitation du signal intégré vertical et du signal intégré horizontal et, d'autre part, une exploitation des signaux d'intensité intégrés.

Un inconvénient du système de mesure 1 décrit ci-dessus en référence aux figures 1 et 2 présente l'inconvénient d'affaiblir les signaux issus des capteurs de champ magnétique 20A, 20C, 20E, 20G, dont l'amplitude est potentiellement faible. En outre, l'introduction de composants, même passifs, génère des perturbations pour les signaux à haute fréquence. Il en résulte une dégradation de la précision de mesure.

L'invention remédie à ces inconvénients en introduisant une différenciation de l'amplitude des signaux issus d'une paire de capteurs de champ magnétique par des inductances différentes de leurs boucles. Autrement dit, dans chaque paire de capteurs de position, les capteurs de champ magnétique comportent des boucles d'inductances différentes l'une de l'autre.

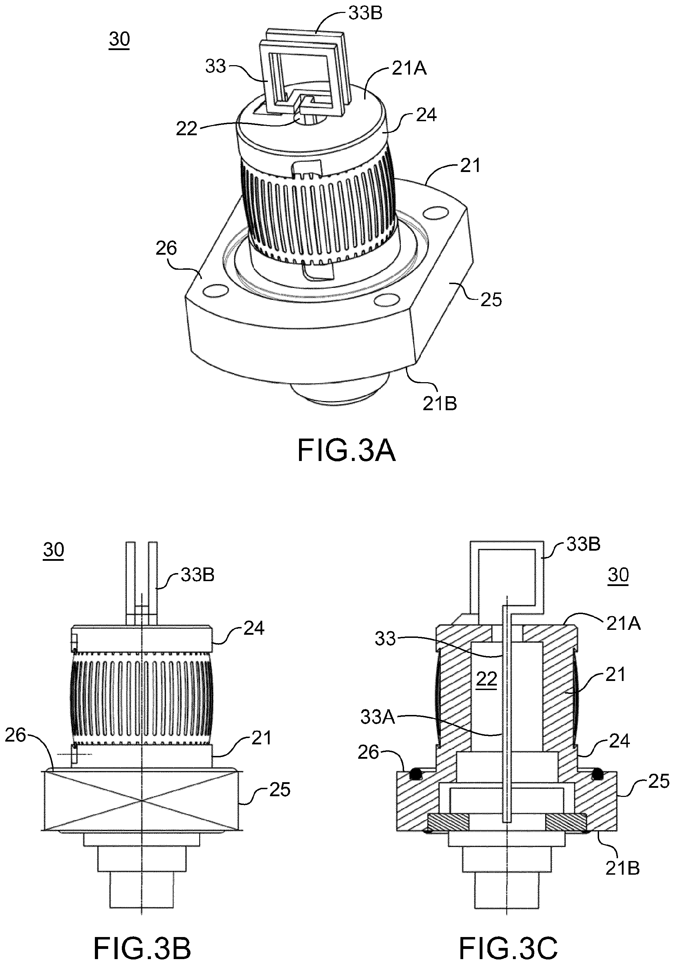

Les figures 3A, 3B et 3C représentent, dans une vue en perspective, dans une vue de côté et dans une vue en coupe longitudinale, respectivement, un exemple de capteur de champ magnétique 30 présentant une inductance différente de celle du capteur de champ magnétique 20 de la figure 2. De manière identique au capteur de champ magnétique 20, le capteur de champ magnétique 30 comporte un corps 21 et un trou débouchant 22. Le corps 21 comprend une partie tubulaire 24, agencée pour pouvoir être insérée dans une cavité de réception du châssis 10 du détecteur de position de faisceau 2, et une embase 25 formant un épaulement 26 agencé pour venir en appui sur la surface extérieure du châssis 10. Le trou débouchant 22 s'étend entre la première extrémité 21A et la deuxième extrémité 21B du corps 21. Le capteur de champ magnétique 30 comporte en outre un élément conducteur 33 comprenant une partie rectiligne 33A s'étendant entre les extrémités 21A et 21B du corps 21, et une boucle 33B formée du côté de l'extrémité 21A. La boucle 33B est connectée par son extrémité libre au corps 21. Le capteur de champ magnétique 30 se distingue du capteur de champ magnétique 20 de la figure 2 en ce que la boucle 33B comporte une double spire. L'inductance de la boucle 33B est donc le double de celle de la boucle 23B.

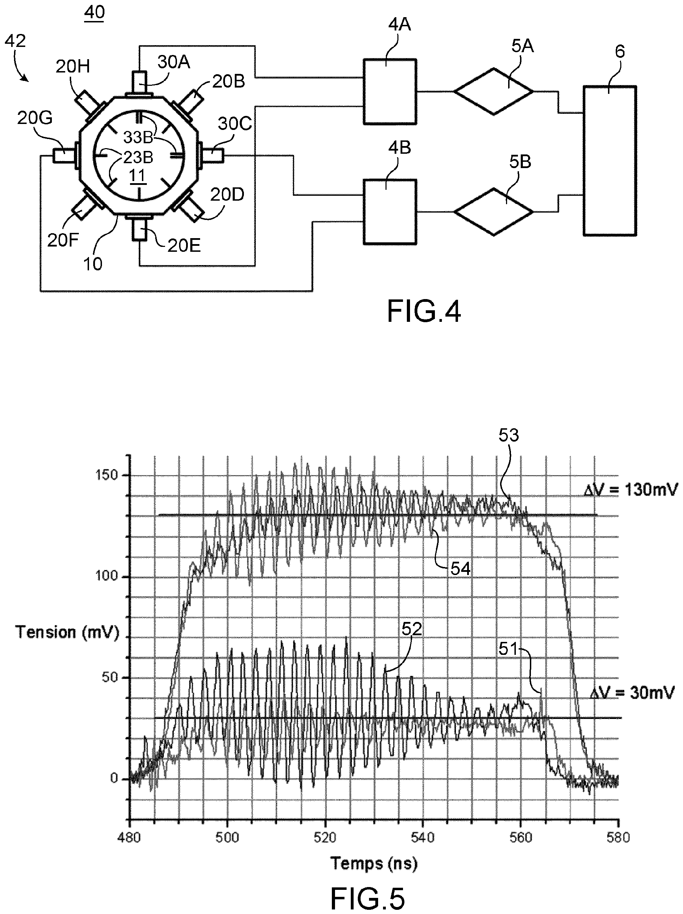

La figure 4 représente schématiquement un exemple de système de mesure selon l'invention. Le système de mesure 40 comprend un détecteur de position de faisceau 42, deux additionneurs 4A, 4B, deux intégrateurs 5A, 5B et un numériseur 6. Les additionneurs 4A, 4B, les intégrateurs 5A, 5B et le numériseur 6 sont identiques aux éléments de la figure 1 portant les mêmes références. Le détecteur de position de faisceau 42 comprend un châssis 10 identique au châssis du détecteur de position de faisceau 2, deux capteurs de champ magnétique 30A et 30C, et six capteurs de champ magnétique 20B, 20D, 20E, 20F, 20G et 20H. Les capteurs de champ magnétique 30A et 30C présentent la structure du capteur de champ magnétique 30 des figures 3A, 3B et 3C, et sont désignés globalement par la référence 30. Les capteurs de champ magnétique 20B, 20D, 20E, 20F, 20G et 20H présentent la structure du capteur de champ magnétique 20 de la figure 2 et sont désignés globalement par la référence 20. Les capteurs de champ magnétique 20, 30 du détecteur de position de faisceau 42 sont installés sur le châssis 10 de manière identique aux capteurs de champ magnétique 20 du détecteur de position de faisceau 2, hormis le remplacement des capteurs de champ magnétique 20A et 20C par les capteurs de champ magnétique 30A et 30C, respectivement. Ainsi, les capteurs de champ magnétique 30A et 20E sont disposés sur l'axe vertical et forment une paire de capteurs de position verticale. Les capteurs 30C et 20G sont disposés sur l'axe horizontal et forment une paire de capteurs de position horizontale. Dans chaque paire de capteurs de position, le capteur de champ magnétique 30A, 30C de la voie positive comporte une boucle formée de deux spires alors que le capteur de champ magnétique 20E et 20G de la voie négative comporte une boucle formée d'une seule spire. Les inductances des capteurs de champ magnétique de chaque paire sont donc différentes, ce qui conduit à la génération de tensions d'amplitudes différentes sur les voies positives et négatives pour un faisceau d'électrons centré. La présence d'atténuateurs peut ainsi être évitée.

L'additionneur 4A est relié par sa première entrée au capteur de champ magnétique 30A et par sa deuxième entrée au capteur de champ magnétique 20E. Il additionne les tensions délivrées par ces capteurs de champ magnétique pour délivrer un signal de différence verticale dont l'amplitude correspond à la différence entre l'amplitude de la tension aux bornes du capteur de champ magnétique 30A et l'amplitude de la tension aux bornes du capteur de champ magnétique 20E. De manière analogue, l'additionneur 4B est relié par sa première entrée au capteur de champ magnétique 30C et par sa deuxième entrée au capteur de champ magnétique 20G. Il additionne les tensions délivrées par ces capteurs de champ magnétique pour délivrer un signal de différence horizontale dont l'amplitude correspond à la différence entre l'amplitude de la tension aux bornes du capteur de champ magnétique 30C et l'amplitude de la tension aux bornes du capteur de champ magnétique 20G. Une sortie de l'additionneur 4A est reliée à une entrée de l'intégrateur 5A et une sortie de l'additionneur 4B est reliée à une entrée de l'intégrateur 5B. L'intégrateur 5A intègre dans le domaine temporel le signal de différence verticale pour donner un signal intégré vertical et l'intégrateur 5B intègre dans le domaine temporel le signal de différence horizontale pour donner un signal intégré horizontal. Une sortie de l'intégrateur 5A et une sortie de l'intégrateur 5B sont reliées individuellement à des entrées du numériseur 6 agencé pour numériser les signaux intégrés. Les signaux intégrés numérisés peuvent ensuite faire l'objet d'un traitement du signal afin de déterminer une position du faisceau d'électrons dans le plan de mesure. Les autres capteurs de champ magnétique 20B, 20D, 20F et 20H peuvent être reliés de manière identique au système de mesure 1 de façon à déterminer une intensité du faisceau d'électrons.

La figure 5 représente, sur un graphique, des exemples de signaux intégrés obtenus avec le système de mesure 1 de la figure 1 et avec le système de mesure 40 de la figure 4 lors du passage d'un faisceau d'électrons. Sur ce graphique, l'axe des abscisses représente le temps, en nanosecondes, et l'axe des ordonnées représente l'amplitude de la tension de chaque signal intégré, en millivolts. Une première courbe 51 représente le signal intégré vertical en sortie de l'intégrateur 5A du système de mesure 1; une deuxième courbe 52 représente le signal intégré horizontal en sortie de l'intégrateur 5B du système de mesure 1 ; une troisième courbe 53 représente le signal intégré vertical en sortie de l'intégrateur 5A du système de mesure 40; et une quatrième courbe 54 représente le signal intégré horizontal en sortie de l'intégrateur 5B du système de mesure 40. Avant le passage d'un faisceau d'électrons, les signaux intégrés présentent une amplitude nulle. Avec le passage du faisceau d'électrons dans le plan de mesure, l'amplitude des signaux intégrés commence par croître à l'approche du faisceau, puis l'amplitude oscille autour d'une valeur moyenne pendant la durée du passage du faisceau, et décroît jusqu'à la valeur nulle avec l'éloignement du faisceau. Il est à remarquer que, au cours du passage du faisceau d'électrons, l'amplitude moyenne des signaux intégrés du système de mesure 1 est sensiblement égale à 30 mV, alors que l'amplitude moyenne des signaux intégrés du système de mesure 40 est sensiblement égale à 130 mV. L'amplitude moyenne des signaux intégrés du système de mesure 40 est ainsi environ 4 fois supérieure à celle des signaux intégrés du système de mesure 1. Ce rapport s'explique d'une part par l'absence d'atténuateurs et, d'autre part, par la présence des boucles à double spire. Le rapport signal sur bruit des signaux intégrés du système de mesure 40 est nettement supérieur à celui des signaux intégrés du système de mesure 1. En conséquence, la position du faisceau d'électrons dans le plan de mesure peut être déterminée avec une bien meilleure précision. Dans le cas d'un accélérateur de particules, la position du faisceau d'électrons peut alors être corrigée plus précisément.

Dans la présente description, les capteurs de champ magnétique d'un couple de capteurs de position présentent un nombre de spires égal à un ou deux. La différence d'inductance entre deux capteurs de champ magnétique peut également être réalisée par toute paire de nombres entiers différents, par exemple 1 et 3, 1 et 4, 2 et 3 ou 2 et 4. La différence d'inductance peut par ailleurs être réalisée en faisant varier d'autres paramètres des boucles, tels que leur forme et leur dimension.

## Revendications

1. Détecteur de position de faisceau pour mesurer une position d'un faisceau de particules chargées traversant une enceinte, le détecteur de position de faisceau (42) comprenant un premier capteur de champ magnétique (30A) et un deuxième capteur de champ magnétique (20E) agencés pour être installés dans l'enceinte de part et d'autre du faisceau de particules, chaque capteur de champ magnétique (30A, 20E) comprenant une boucle conductrice (23B, 33B), le détecteur de position de faisceau (42) étant **caractérisé en ce que** la boucle conductrice (33B) du premier capteur de champ magnétique (30A) et la boucle conductrice (23B) du deuxième capteur de champ magnétique (20E) sont agencées pour présenter des inductances différentes l'une de l'autre.

2. Détecteur de position de faisceau selon la revendication 1, dans lequel la boucle conductrice (33B) du premier capteur de champ magnétique (30A) et la boucle conductrice (23B) du deuxième capteur de champ magnétique (20E) présentent des nombres de spires différents l'un de l'autre et/ou des formes différentes l'une de l'autre et/ou des dimensions différentes l'une de l'autre.

3. Détecteur de position de faisceau selon l'une des revendications 1 et 2, dans lequel la boucle conductrice (33B) du premier capteur de champ magnétique (30A) et la boucle conductrice (23B) du deuxième capteur de champ magnétique (20E) présentent chacune une seule spire, de formes différentes l'une de l'autre et/ou de dimensions différentes l'une de l'autre.

4. Détecteur de position de faisceau selon l'une des revendications 1 et 2, dans lequel la boucle conductrice (33B) du premier capteur de champ magnétique (30A) et la boucle conductrice (23B) du deuxième capteur de champ magnétique (20E) présentent des spires de même forme et de mêmes dimensions en nombres différents.

5. Détecteur de position de faisceau selon l'une des revendications précédentes comprenant, en outre, un troisième capteur de champ magnétique (30C) et un quatrième capteur de champ magnétique (20G) agencés pour être installés dans l'enceinte de part et d'autre du faisceau de particules, chaque capteur de champ magnétique (30C,20G) comprenant une boucle conductrice (23B, 33B), la boucle conductrice (33B) du troisième capteur de champ magnétique (30C) et la boucle conductrice (23B) du quatrième capteur de champ magnétique (20G) étant agencées pour présenter des inductances différentes l'une de l'autre.

6. Détecteur de position de faisceau selon la revendication 5, dans lequel le premier capteur de champ magnétique (30A), le deuxième capteur de champ magnétique (20E), le troisième capteur de champ magnétique (30C) et le quatrième capteur de champ magnétique (20G) sont agencés dans un même plan perpendiculaire au faisceau de particules.

7. Détecteur de position de faisceau selon l'une des revendications précédentes comprenant, en outre, un châssis (10) agencé pour être fixé à l'enceinte et/ou former un tronçon de l'enceinte, le châssis (10) comprenant :
▪ une ouverture centrale (11) agencée pour laisser passer le faisceau de particules, et
▪ une cavité de réception pour chaque capteur de champ magnétique (30A, 30C, 20B, 20D, 20E, 20F, 20G, 20H), chaque cavité de réception débouchant dans l'ouverture centrale (11) et étant agencée pour recevoir l'un des capteurs de champ magnétique.

8. Système de mesure comprenant un détecteur de position de faisceau (42) selon l'une des revendications précédentes et un premier additionneur (4A), le premier additionneur étant agencé pour délivrer un premier signal de différence représentatif d'une différence d'amplitude entre un signal délivré par le premier capteur de champ magnétique (30A) et un signal délivré par le deuxième capteur de champ magnétique (20E).

9. Système de mesure selon la revendication 8 comprenant, en outre, un premier intégrateur (5A) agencé pour recevoir le premier signal de différence et délivrer un premier signal intégré correspondant à une intégration temporelle du premier signal de différence.

10. Système de mesure selon l'une des revendications 8 et 9, comprenant le détecteur de position (42) selon la revendication 5 et un deuxième additionneur (4B), le deuxième additionneur étant agencé pour délivrer un deuxième signal de différence représentatif d'une différence d'amplitude entre un signal délivré par le troisième capteur de champ magnétique (30C) et un signal délivré par le quatrième capteur de champ magnétique (20G).

11. Système de mesure selon la revendication 10 comprenant, en outre, un deuxième intégrateur (5B) agencé pour recevoir le deuxième signal de différence et délivrer un deuxième signal intégré correspondant à une intégration temporelle du deuxième signal de différence.

12. Système de mesure selon l'une des revendications 8 à 11, dans lequel chaque additionneur (4A, 4B) est connecté directement aux capteurs de champ magnétique (30A, 30C, 20E, 20G).

13. Système de mesure selon l'une des revendications 8 à 12, prise avec la revendication 9, comprenant en outre un numériseur (6) agencé pour recevoir chaque signal intégré au format analogique et délivrer un signal intégré numérisé correspondant.

14. Accélérateur de particules comprenant une enceinte agencée pour guider un faisceau de particules chargées, et le détecteur de position de faisceau (42) selon la revendication 7 ou le système de mesure (40) selon l'une des revendications 8 à 13.

## Patentansprüche

1. Strahlpositionsdetektor zum Messen einer Position eines Strahls geladener Teilchen, der ein Gehäuse durchdringt, wobei der Strahlpositionsdetektor (42) einen ersten Magnetfeldsensor (30A) und einen zweiten Magnetfeldsensor (20E) umfasst, die für den Einbau im Gehäuse auf beiden Seiten des Teilchenstrahls eingerichtet sind, wobei jeder Magnetfeldsensor (30A, 20E) eine leitende Schleife (23B, 33B) umfasst, wobei der Strahlpositionsdetektor (42) **dadurch gekennzeichnet ist, dass** die leitende Schleife (33B) des ersten Magnetfeldsensors (30A) und die leitende Schleife (23B) des zweiten Magnetfeldsensors (20E) eingerichtet sind, um voneinander unterschiedliche Induktivitäten aufzuweisen.

2. Strahlpositionsdetektor nach Anspruch 1, wobei die leitende Schleife (33B) des ersten Magnetfeldsensors (30A) und die leitende Schleife (23B) des zweiten Magnetfeldsensors (20E) voneinander unterschiedliche Windungsmengen und/oder voneinander unterschiedliche Formen und/oder voneinander unterschiedliche Abmessungen aufweisen.

3. Strahlpositionsdetektor nach einem der Ansprüche 1 und 2, wobei die leitende Schleife (33B) des ersten Magnetfeldsensors (30A) und die leitende Schleife (23B) des zweiten Magnetfeldsensors (20E) jeweils eine einzige Windung mit voneinander unterschiedlichen Formen und/oder voneinander unterschiedlichen Abmessungen aufweisen.

4. Strahlpositionsdetektor nach einem der Ansprüche 1 und 2, wobei die leitende Schleife (33B) des ersten Magnetfeldsensors (30A) und die leitende Schleife (23B) des zweiten Magnetfeldsensors (20E) Windungen derselben Form und Abmessung in unterschiedlichen Mengen aufweisen.

5. Strahlpositionsdetektor nach einem der vorhergehenden Ansprüche, ferner einen dritten Magnetfeldsensor (30C) und einen vierten Magnetfeldsensor (20G) umfassend, die für den Einbau im Gehäuse auf beiden Seiten des Teilchenstrahls eingerichtet sind, wobei jeder Magnetfeldsensor (30C, 20G) eine leitende Schleife (23B, 33B) umfasst, wobei die leitende Schleife (33B) des dritten Magnetfeldsensors (30C) und die leitende Schleife (23B) des vierten Magnetfeldsensors (20G) eingerichtet sind, um voneinander unterschiedliche Induktivitäten aufzuweisen.

6. Strahlpositionsdetektor nach Anspruch 5, wobei der erste Magnetfeldsensor (30A), der zweite Magnetfeldsensor (20E), der dritte Magnetfeldsensor (30C) und der vierte Magnetfeldsensor (20G) in derselben Ebene senkrecht zum Teilchenstrahl eingerichtet sind.

7. Strahlpositionsdetektor nach einem der vorhergehenden Ansprüche, ferner einen Rahmen (10) umfassend, eingerichtet, um am Gehäuse befestigt zu werden und/oder einen Abschnitt des Gehäuses zu bilden, wobei der Rahmen (10) umfasst:
- eine zentrale Öffnung (11), eingerichtet, um den Teilchenstrahl durchgehen zu lassen,
und
- einen Aufnahmehohlraum für jeden Magnetfeldsensor (30A, 30C, 20B, 20D, 20E, 20F, 20G, 20H), wobei jeder Aufnahmehohlraum in die zentrale Öffnung (11) mündet und eingerichtet ist, um einen der Magnetfeldsensoren zu empfangen.

8. Messsystem, einen Strahlpositionsdetektor (42) nach einem der vorhergehenden Ansprüche umfassend, und einen ersten Addierer (4A), wobei der erste Addierer eingerichtet ist, um ein erstes Differenzsignal zu liefern, repräsentativ für eine Amplitudendifferenz zwischen einem vom ersten Magnetfeldsensor (30A) gelieferten Signal und einem vom zweiten Magnetfeldsensor (20E) gelieferten Signal.

9. Messsystem nach Anspruch 8, ferner einen ersten Integrator (5A) umfassend, eingerichtet, um das erste Differenzsignal zu empfangen und ein erstes integriertes Signal zu liefern, das einer zeitlichen Integration des ersten Differenzsignals entspricht.

10. Messsystem nach einem der Ansprüche 8 und 9, den Positionsdetektor (42) nach Anspruch 5 umfassend, und einen zweiten Addierer (4B), wobei der zweite Addierer eingerichtet ist, um ein zweites Differenzsignal zu liefern, repräsentativ für eine Amplitudendifferenz zwischen einem vom dritten Magnetfeldsensor (30C) gelieferten Signal und einem vom vierten Magnetfeldsensors (20G) gelieferten Signal.

11. Messsystem nach Anspruch 10, ferner einen zweiten Integrator (5B) umfassend, eingerichtet, um das zweite Differenzsignal zu empfangen und ein zweites integriertes Signal zu liefern, das einer zeitlichen Integration des zweiten Differenzsignals entspricht.

12. Messsystem nach einem der Ansprüche 8 bis 11, wobei jeder Addierer (4A, 4B) direkt mit den Magnetfeldsensoren (30A, 30C, 20E, 20G) verbunden ist.

13. Messsystem nach einem der Ansprüche 8 bis 12 zusammen mit Anspruch 9, ferner einen Digitalisierer (6) umfassend, eingerichtet, um jedes integrierte Signal im analogen Format zu empfangen und ein entsprechendes digitalisiertes integriertes Signal zu liefern.

14. Teilchenbeschleuniger, ein Gehäuse umfassend, eingerichtet, um einen Strahl geladener Teilchen zu führen, und den Strahlpositionsdetektor (42) nach Anspruch 7, oder das Messsystem (40) nach einem der Ansprüche 8 bis 13.

## Claims

1. Beam position monitor for measuring a position of a beam of charged particles passing through a chamber, the beam position monitor (42) comprising a first magnetic field sensor (30A) and a second magnetic field sensor (20E) arranged to be installed in the chamber on either side of the beam of particles, each magnetic field sensor (30A, 20E) comprising a conductive loop (23B, 33B), the beam position monitor (42) being **characterized in that** the conductive loop (33B) of the first magnetic field sensor (30A) and the conductive loop (23B) of the second magnetic field sensor (20E) are arranged to have inductances different from one another.

2. Beam position monitor according to claim 1, wherein the conductive loop (33B) of the first magnetic field sensor (30A) and the conductive loop (23B) of the second magnetic field sensor (20E) have numbers of turns different from one another and/or shapes different from one another and/or dimensions different from one another.

3. Beam position monitor according to one of claims 1 and 2, wherein the conductive loop (33B) of the first magnetic field sensor (30A) and the conductive loop (23B) of the second magnetic field sensor (20E) each have a single turn, having shapes different from one another and/or dimensions different from one another.

4. Beam position monitor according to one of claims 1 and 2, wherein the conductive loop (33B) of the first magnetic field sensor (30A) and the conductive loop (23B) of the second magnetic field sensor (20E) have turns having the same shape and the same dimensions in different numbers.

5. Beam position monitor according to one of the previous claims, further comprising a third magnetic field sensor (30C) and a fourth magnetic field sensor (20G) arranged to be installed in the chamber on either side of the beam of particles, each magnetic field sensor (30C, 20G) comprising a conductive loop (23B, 33B), the conductive loop (33B) of the third magnetic field sensor (30C) and the conductive loop (23B) of the fourth magnetic field sensor (20G) being arranged to have inductances different from one another.

6. Beam position monitor according to claim 5, wherein the first magnetic field sensor (30A), the second magnetic field sensor (20E), the third magnetic field sensor (30C) and the fourth magnetic field sensor (20G) are arranged in the same plane perpendicular to the beam of particles.

7. Beam position monitor according to one of the previous claims, further comprising a chassis (10) arranged to be fastened to the chamber and/or to form a section of the chamber, the chassis (10) comprising:
▪ a central opening (11) arranged to let the beam of particles pass, and
▪ a receiving cavity for each magnetic field sensor (30A, 30C, 20B, 20D, 20E, 20F, 20G, 20H), each receiving cavity opening into the central opening (11) and being arranged to receive one of the magnetic field sensors.

8. Measurement system comprising a beam position monitor (42) according to one of the previous claims and a first adder (4A), the first adder being arranged to deliver a first difference signal representative of a difference in amplitude between a signal delivered by the first magnetic field sensor (30A) and a signal delivered by the second magnetic field sensor (20E).

9. Measurement system according to claim 8, further comprising a first integrator (5A) arranged to receive the first difference signal and deliver a first integrated signal corresponding to an integration over time of the first difference signal.

10. Measurement system according to one of claims 8 and 9, comprising the position monitor (42) according to claim 5 and a second adder (4B), the second adder being arranged to deliver a second difference signal representative of a difference in amplitude between a signal delivered by the third magnetic field sensor (30C) and a signal delivered by the fourth magnetic field sensor (20G).

11. Measurement system according to claim 10, further comprising a second integrator (5B) arranged to receive the second difference signal and deliver a second integrated signal corresponding to an integration over time of the second difference signal.

12. Measurement system according to one of claims 8 to 11, wherein each adder (4A, 4B) is connected directly to the magnetic field sensors (30A, 30C, 20E, 20G).

13. Measurement system according to one of claims 8 to 12, taken with claim 9, further comprising a digitizer (6) arranged to receive each integrated signal in analog form and deliver a corresponding digitized integrated signal.

14. Particle accelerator comprising a chamber arranged to guide a beam of charged particles, and the beam position monitor (42) according to claim 7 or the measurement system (40) according to one of claims 8 to 13.
